# EUROPEAN PATENT SPECIFICATION

(11) **EP 3 849 006 B1**
(45) Date of publication and mention of the grant of the patent: **02.12.2026**
(21) Application number: 20150865.2
(22) Date of filing: 09.01.2020
(51) Int. Cl.: H05K 1/189, H01M 10/04, H05K 3/00, H05K 3/328, H05K 1/18, H01M 10/42

(54) **BATTERY SYSTEM WITH FLEXIBLE PRINTED CIRCUIT**
BATTERIESYSTEM MIT FLEXIBLER LEITERPLATTE
SYSTÈME DE BATTERIE DOTÉ D'UN CIRCUIT IMPRIMÉ SOUPLE

(43) Date of publication of application: 14.07.2021
(73) Proprietor: Samsung SDI Co., Ltd., Gyeonggi-do 17084 (KR)
(72) Inventor: Erhart, Michael, 8054 Seiersberg-Pirka (AT)
(74) Representative: Gulde & Partner

(56) References cited:
- EP-A2- 0 488 580
- WO-A1-00/65888

## Description

### Field of the Invention

The present invention generally relates to various aspects of a battery system with a flexible printed circuit. Particularly, the present invention relates to a method for connecting a flexible printed circuit, FPC, to a battery system, to a tool for connecting a flexible printed circuit, FPC, to a battery system and to a battery system comprising a plurality of battery modules interconnected via a flexible printed circuit in a method according to the present invention.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for electronic devices, such as cellular phones, notebooks and camcorders, while high-capacity rechargeable batteries are used as power supply for hybrid vehicles or the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs, each battery cell is coupled to a common current collector structure and a common battery management system. In modular designs, pluralities of battery cells are connected to form submodules and several submodules are connected to form the battery module. Battery management functions may be realized either on module or submodule level and thus interchangeability of the components is improved. One or more battery modules are mechanically and electrically integrated, equipped with a thermal management system and set up for communication with electrical consumers in order to form a battery system.

To provide thermal control of a battery system a thermal management system is required to safely use the at least one battery module by efficiently emitting, discharging and/or dissipating heat generated from its rechargeable batteries. If the heat emission/discharge/dissipation is not sufficiently performed, temperature deviations occur between respective battery cells, such that the at least one battery module cannot generate a desired amount of power. In addition, an increase of the internal temperature can lead to abnormal reactions occurring therein and thus charging and discharging performance of the rechargeable deteriorates and the life-span of the rechargeable battery is shortened. Thus, cooling devices for effectively emitting/discharging/dissipating heat from the cells is required.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Battery systems usually comprise a battery management system (BMS) for processing this information.

The BMS is usually coupled to the controller of one or more electrical consumers as well as to each of the battery modules of the battery system. For controlling a plurality of battery modules by a single BMS a daisy chain setup may be used. In such setup, the BMS, as master, is connected for communication in series to a plurality of battery modules, particularly to a plurality of cell supervision circuits, CSC, of the respective battery modules. Therein, the BMS is configured to receive and process information of each of the CSCs as well as of external consumer or control units, e.g. a vehicle board net, connected thereto. Further, each of the CSCs is configured to detect voltages and/or temperatures of an individual battery module and to communicate the detected voltages and/or temperatures to the BMS. The CSCs may be further configured for cell balancing within the battery modules.

In order to detect cell voltages and/or cell temperatures, the CSCs are connected to battery cells or busbars of the respective battery modules. These connections between the CSCs and the battery modules can be carried out using wire bonds. However the application of wire bond is a rather slow and cost-intensive process. Particularly, the flexible printed circuits can be used for establishing a connection between a circuit carrier of the CSCs and the battery modules. However, the connection of a flexible printed circuit to a battery module is usually carried out manually or semi-automatic with an additional holding structure. Hence, the use of flexible printed circuit connections is usually cumbersome and cost-intensive.

It is thus an object of the present invention to overcome or reduce at least some of the drawbacks of the prior art and to provide solutions for connecting a flexible printed circuit to a battery system, particularly for connecting the battery module and a cell supervision circuit.

WO 0065888 A1 is a relevant prior art.

### Summary of Invention

One or more of the drawbacks of the prior art could be avoided or at least reduced by means of the present invention. According to an aspect of the invention, a method for connecting a flexible printed circuit, FPC, to a battery system is provided. Therein, the battery system comprises at least one, preferably a plurality, of battery modules and further comprises at least one, preferably a plurality of cell supervision circuits, CSCs mounted to at least one, circuit carrier board, CSCB (usually it is one CSCB per CSC).

A battery module preferably comprises a plurality of aligned battery cells, i.e., a plurality of battery cells that are stacked in a lengthwise direction of the battery module. Further preferred, the battery module comprises a plurality of stacked prismatic battery cells. Each of the battery cells preferably comprises a cell case and a cap assembly placed on the cell case for closing the cell case. According to an embodiment, the battery cell comprises an electrode assembly, a negative cell terminal and a positive cell terminal, wherein one of the cell terminals may be constituted by or at least connected to the cell case of a battery cell.

The cell supervision circuit is mounted to a cell supervision circuit board, CSCB. In other words, the CSCB is configured to host a cell supervision circuit, CSC, or is hosting a CSC. Therein, a CSC refers to a microprocessor, ASIC, or any (integrated) circuit that is configured to receive signals corresponding to the voltage and/or temperature of at least one battery cell of the module. Preferably, the CSC is further configured to process, analyze and/or store the received signals and the CSC may be further configured to transmit signals related to the received signals to another CSC and/or a BMS. Further preferred, the CSC may be configured to perform at least one control function with respect to the battery module or with respect to at least one battery cells thereof. Therein, control functions may comprise measurements or determinations of cell voltages, currents, resistances or capacities and may further comprise the active or passive balancing of cell voltages or cell currents of cells.

The method of the present invention comprises at least the following steps. In a first step of the present invention, a coil of a continuous and strip-shaped flexible printed circuit, FPC, is provided. Therein, the FPC preferably comprises a flexible substrate as commonly used for flexible printed circuits, such as e.g., polyimide, PEEK or transparent conductive polyester film. On or in the flexible substrate, electrically conductive structures are provided that can be used for electrically connecting nodes using the FPC. The conductive structures may be planar conductive structures that are formed on an outer or inner surface of the FPC. Further, the conductive structures may be formed by surface metallizations, conductive inks, or the like. Also preferred, the conductive structures are disposed within the substrate, e.g., covered by an insulating substrate layer on both sides of the conductive structure. In such case, the conductive structures are locally exposed through at least one insulating layer.

According to the method of the present invention, the coil of continuous and strip-shaped FPC is provided via a coil holder of a tool according to the invention as described below. Therein, the coil on the coil holder stores a reservoir of FPC and the FPC can be unwind of the FPC, e.g., by rotating the coil holder such that a section of FPC extends linearly thereof. The coil holder is preferably mounted to a tool head of the tool of the present disclosure, wherein the tool head is configured to perform translational movements in three dimensions.

In a next step of the method, a first section of the FPC is unwind (unrolled) from the FPC coil holder, preferably by rotating the coil holder. The tool head preferably further comprises guiding means for guiding the unwind section of the FPC. Particularly, in the method of the invention the unwind first section of the FPC is positioned over a first contact portion of a battery module of the battery system. Therein, the positioning is preferably performed using the tool head and/or the guiding means. In a next step of the method of the invention a weld connection is formed between a conductive structure of the FPC, wherein the conductive structure is positioned in the first section, and the first contact portion of the battery module. The weld connection is preferably performed by the tool head of the tool of the invention. In other words, in the method of the invention, a first section of FPC is automatically unwind from a coil, automatically positioned over a first contact portion of a battery module and automatically welded to the first contact portion, particularly a conductive structure thereof.

In a next step of the method of the present invention, a second section of the FPC is unwind from the coil and positioned, again preferably by rotating the coil holder and further preferred by simultaneously moving the tool head in a translational manner. The second section of the FPC is then positioned over at least one contact pad of the cell supervision circuit board, CSCB, particularly preferred by the translational movement of the tool head. Then, another weld connection is formed between the conductive structure in the second section of the FPC and the contact pad of the CSCB. Again, all the aforementioned steps of the claimed method are preferably carried out fully automatic, particularly preferred by the tool head.

In a final step of the method of the present disclosure, the first section of the FPC and the second section of the FPC are cut from the continuous coil of FPC. In other words, a piece of the FPC comprising at least the first section and the second section is cut from the continuous FPC. After the cutting of the first and second section from the coil, the contact pad of the CSCB and the first contact portion of the battery module are electrically connected via the conductive structure of the FPC that is welded to the first contact portion in the first section and that is welded to the contact pad in the second section. Further, after the cutting of the first and second section from the coil, the steps of the method of the invention can be repeated for again connecting a contact portion of a battery module with a contact pad.

The method of the present application advantageously allows for a fully automated and flexible assembly process of the flexible printed circuit in a battery production process. Particularly due to the continuous connection method of the invention, there is no need for an additional holder used for mounting the FPC. Rather, a continuous FPC coil is assembled and welded in an fully automatic process onto the cells, wherein the FPC has a simple design of being a long single FPC strip that can be rolled out, welded and cut automatically. Hence, the method of the invention allows for various connection designs of the FPC.

In a preferred embodiment of the present invention, the first contact portion of the battery module is a battery cell terminal, a battery cell case or a busbar. By connecting the FPC in the first section of the FPC to such first contact portion of a battery module, a reliable voltage signal of the battery module is advantageously obtained from the battery module. By tapping such first contact portions of individual battery cell, individual voltage readings are obtained.

However, in an alternatively preferred embodiment, the FPC is connected to a first contact portion and is further connected to a second contact portion of the battery module. In other words, after a weld connection is formed between the conductive structure in the first section of the FPC and the first contact portion of the battery module and before the weld connection is formed between the conductive structure in the second section of the FPC and the contact pad of the CSCB, another weld connection is formed between the conductive structure in another (third) section of the FPC and the second contact portion of the battery module. Further, the FPC may be connected to a plurality of second contact portions of another or the same battery module of a battery system via weld connections in other sections of the FPC.

In a particularly preferred embodiment, the first contact portion may be a negative terminal of a battery cell and a second contact portion may be positive terminal of another battery cell. In such embodiment, the CSC is advantageously able to receive voltage signals corresponding to the voltage of each of the connected battery cells of the battery module. Hence, voltage signals corresponding to a whole battery module can be obtained. Further preferred, the second contact portion is of another battery module than that of the first contact portion.

In the aforementioned embodiment, the first contact portion and the second contact portion are preferably connected to the conductive structure of the FPC. In other words, the first contact portion and the second contact portion are connected, via respective weld connections, to the same conductive structure of the FPC. Hence, a voltage signal corresponding to the whole battery module can be obtained via the conductive structure.

In an alternatively preferred embodiment, the FPC comprises a first conductive structure and a second conductive structure that is different from the first conductive structure. According to such embodiment, the first contact portion is connected to the first conductive structure and the second contact portion is connected to the second conductive structure. Hence, voltage signals corresponding to the individual battery cells can be advantageously obtained via the first conductive structure and the second conductive structure, respectively. The FPC may comprise a plurality of conductive structures, i.e., further (third) conductive structures that might be connected to further contact portions of the battery module in respective (third) sections along a length extension of the FPC. Preferably, a single FPC might be used to electrically contact each battery cell of a battery module in an individual manner, i.e., via an individual conductive structure. Hence, the FPC may comprise a conductive structure for each battery cell of a battery module. However, the FPC may also comprise a conductive structure per a group of cells of a battery module, i.e., a cell group is tapped by one structure.

In a further preferred embodiment of the method, the first conductive structure of the FPC is connected to a first CSCB contact pad of a CSCB and the second conductive structure is connected to a second CSCB contact pad of the same CSCB. In other words, the CSCB of this embodiment comprises multiple contact pads and after the step of forming the (first) weld connection between the first conductive structure in the second section of the FPC and the first contact pad of the CSCB another (second) weld connection is formed between the second conductive structure in the second section of the FPC and the second contact pad of the CSCB. Further preferred, if the FPC comprise at least one other (third) conductive structure and the CSCB comprises at least one other (third) contact pad, more weld connections can be formed between respective conductive structures and contact pads. Further preferably, an individual contact pad is provided for each conductive structure. However, contact pads may also be provided for groups of conductive structures of the FPC.

Preferably, in the method of the present invention further a cell supervision circuit, CSC, is disposed on the CSCB and is connected to the at least one contact pad of the CSCB. Particularly, the CSCB may comprise a single CSC contact pad line for connecting an input node of the CSC to a single contact pad or even to a plurality of contact pads for sequential measurements. Also preferred, the CSCB may comprise a plurality of contact pad lines for connecting a plurality of input nodes of the CSC to respective individual contact pads for simultaneous measurements. The CSC preferably further comprises communication pads that are connected to the CSC, particularly to communication nodes thereof, via respective CSC communication lines formed as conductive structures on the CSCB. Preferably, the CSC communication line is separate from the at least one CSC contact pad line. Via the communication pads, the communication lines and the communication nodes a CSC can be connected to other CSCs on other CSCBs or a BMS, preferably in a daisy chain setup.

Another aspect of the present invention relates to a tool for connecting a flexible printed circuit, FPC, to a battery module in the method of the present invention as described above as defined in claim 8. Therefore, the tool of the present invention comprises a tool head that might be one of multiple tool heads. However, the tool may also consist of the tool head and a mount for the tool head. According to the present invention, the tool head comprises a coil holder that is configured for receiving a coil of a continuous and strip-shaped FPC. The coil holder is rotatable such that a section of the continuous coil of FPC is unwound from the coil by the rotation of the coil holder. The tool hold further comprises guiding means that are configured to receive a section of unwound FPC and for guiding the section of unwound FPC into an area that is parallel to a contact portion of a battery module.

The tool head is further configured for performing a translational movement in three dimensions in an area that is parallel to a contact portion of a battery module and that is preferably also parallel to a contact pad of a CSCB, , e.g., in an x-direction and in an y-direction. Further, the tool head is configured for performing a translational movement in a direction parallel to normal vectors of the contact portion(s) of the battery module and preferably of the CSCB contact pad. The tool head is preferably moved by a rack and pinion drive system, a linear motor or the like. The skilled person is aware of systems for realizing a 3D movement of a tool head.

The tool head of the present invention further comprises an optical sensor for detecting a position of the unrolled FPC. The tool head may also comprise a plurality of optical sensors for detecting a position of the unrolled FPC in different dimensions. Exemplarily, the section of the FPC may be unrolled from the coil of the FPC in a direction parallel to a normal vector of a contact portion before being deflected by the guiding means into an area parallel to the contact portion. The tool head then preferably comprises an optical sensor for detecting the position, i.e., the length of the unwound FPC in the direction parallel to the normal vector. In other words, the first optical sensor is used for detecting a length of an unwound FPC section. Further preferred, the tool head comprises at least one other optical sensor, which may also be a camera, for detection a position of the unwound FPC with respect to the contact portion of the battery module or with respect to the CSCB contact pad. Such optical sensor may be configured to detect the position of the FPC relative an alignment indicator.

The tool head of the present application further comprises means for making a weld connection between a conductive structure of the FPC with the contact portion and with the CSCB contact pad. As mentioned above, the FPC comprises a conductive structure that is either formed on or in the FPC. The means for making a weld connection are preferably configured for locally liquefying the conductive structure for forming a mechanical stable and electrically conductive weld connection to the contact portion of the battery module or with the contact pad of the CSCB. The means for making a weld connection may comprise means for arc welding, gas welding or energy beam welding. Particularly preferred, the means for making the weld connection comprise a laser that is configured for making a laser weld connection between the FPC and the contact portion and the CSCB contact pad.

Further preferred, the tool head of the tool according to the present invention is configured for performing a rotational movement around an axis that is parallel to the normal direction of the contact portion of the battery module and the contact pad of the CSCB. Hence, by using such tool head the FPC can also be connected to the battery module in a curved configuration in the method of the present invention. This advantageously allows for more complex configurations, e.g., for connecting an FPC to several battery modules and to a CSCB. Such configurations are advantageously possible due to the flexibility of the FPC.

Further preferred, the tool head of the tool according to the present invention comprises cutting means for cutting the FPC after making a weld connection between the conductive structure and the CSCB contact pad. As described above, the tool head preferably comprises guiding means for guiding an unwound section of the FPC onto the contact portion of the battery module or the contact pad of the CSCB. The cutting means preferably interact with the FPC while being guided by the guiding means and separate an unwound section of the FPC from the continuous portion of FPC at the coil. The cutting means preferably comprise a cutting edge mounted to the tool head and movable in z-direction. However, the cutting means may also be laser cutting means or a cutting saw for separation.

Another aspect of the present invention is directed to a battery system as defined in claim 12. In other words, the FPC is connected to the battery module and to the contact pad by performing the steps of the method of the invention as described above. Further, the FPC is preferably connected to the contact portions of the battery modules and the contact pads of the CSCBs via a tool head of a tool according to the present invention as described above. Thus, the FPC is connected to the contact portions of the battery module and the CSCB contact pad via weld connections.

Preferably, the FCB (CSCC) comprises at least one curved section between adjacent weld connections. Hence, the FCB does not connect the weld connections along a shortest distance there between, e.g., within a plane that is span by the x- and y-direction, but also extends into a direction normal to the contact portion and contact pad in between them. Preferably, the curved section of the FCB in between two weld pads is curved in a height direction of the battery module. Hence, a material reservoir of the FCB is formed between the weld connections and such material reservoir allows the FCB to compensate for cell swelling or otherwise caused spatial displacements of the battery cells forming the battery module. Hence, the FPC allows to provide sufficient electric contact between the CSC and the battery cells even in the case of cell swelling or spatial displacement of battery cells.

Preferably, in the battery system of the invention, the battery modules are set up in communication with a BMS and/or with each other. Further preferred, the battery system comprises a plurality of identical battery modules, each comprising the same amount of battery cells that are stacked in the same way. Further preferred, the battery system comprises a plurality of identical cell supervision circuit carriers, each being connected to at least one of the battery modules via at least one FPC. Therein, each CSC refers to a microprocessor, ASIC, or any (integrated) circuit that is configured to receive signals corresponding to the voltage and/or temperature of the respective battery module.

Preferably, the CSC is further configured to process, analyze and/or store the received signals and the CSC may be further configured to transmit signals related to the received signals to another CSC and/or a BMS. Further preferred, the CSC may be configured to perform at least one control function with respect to the battery module or with respect to at least one battery cells thereof. Therein the control functions may comprise measurements or determinations of cell voltages, cell currents, cell resistances or cell capacities and may further comprise the active or passive balancing of cell voltages or cell currents of battery cells on the battery module. Particularly preferred, the CSCC is formed of a flexible circuit board, FCB, i.e., of a flexible substrate as commonly used for flexible printed circuits, such as e.g., polyimide, PEEK or transparent conductive polyester film. Any conductive surface structures as described above, e.g., conductive lines, may be printed to the substrate.

In the embodiment of the battery system of the invention, a first FPC is connected to a first battery module and a contact pad of a first CSCB and a second FPC is connected to a second battery module and a contact pad of a second CSCB. In other words, in this embodiment individual FPCs are provided for connecting the battery modules and the respective CSCBs. Preferably the FPCs extend linearly between battery module and CSCB. This embodiment advantageously allows for the use of simple designs of FPC and tool head.

According to another preferred embodiment of the battery system an FPC is connected to at least two battery modules and at least one contact pad of a CSCB. In other words, according to this embodiment, one CSC is connected to at least two battery modules. In this embodiment, the FPC comprises at least one curved section. Particularly preferred, the FPC forms a U-shape, an S-shape, or another shape that comprises at least one curved section. Hence, in this embodiment the FPC is connected to the battery modules with a tool head that is configured to rotate around an axis that is parallel to a normal vector of the contact portion.

In a further preferred embodiment of the battery system of the present invention, the battery system comprises a first CSCB that has a first communication pad and a second CSCB that has a second communication pad. Therein, the first and second communication pads are interconnected via a flexible printed circuit in a method of the invention as described above. Particularly, each of the CSCBs comprises a first communication pad and a second communication pad. In other words, according to this embodiment the CSCs are connected to each other and also preferred to a BMS via at least one FPC. Further preferred, the CSCs and the BMS are connected to each other in a daisy chain arrangement. Advantageously, a battery system with such plurality of connectable CSCBs can be set up for a daisy chain communication with a BMS. Preferable, the cell supervision circuits are configured to transmit and receive digital or analogous signals, e.g. differential signals, via the FPCs and/or via communication pads connecting the CSCs to each other and/or to a BMS.

The cell supervision circuit boards, CSCBs, of the battery system are preferably configured to host a cell supervision circuit, CSC or even host a respective CSC. Therein, a CSC refers to a microprocessor, ASIC, or any (integrated) circuit that is configured to receive signals corresponding to the voltage and/or temperature of at least one battery cell of the module. Preferably, the CSC is further configured to process, analyze and/or store the received signals and the CSC may be further configured to transmit signals related to the received signals to another CSC and/or a BMS. Further preferred, the CSC may be configured to perform at least one control function with respect to the battery module or with respect to at least one battery cells thereof. Therein the control functions may comprise measurements or determinations of cell voltages, cell currents, cell resistances or cell capacities and may further comprise the active or passive balancing of cell voltages or cell currents of cells.

In other words, each CSCB is a substrate that is configured for receiving the CSC thereon or therein, e.g., by providing a suitable chip socket, landing pads or wire frame for a CSC or that is at least configured for being connected to the CSC. The CSCB further comprises communication lines and contact pad lines that are configured for establishing data communication with the CSC. Therein, the communication lines preferably establishes a data communication between the CSC received on or in the CSCB and another CSC and/or a BMS or an external control unit, e.g. a control unit of an external consumer. Further preferred the contact pad lines are configured for reading in signals received by CSCB contact pads.

Further aspects of the present invention are disclosed in the dependent claims, the appended drawing and in the following description thereof.

### Brief Description of the Drawings

Features will become apparent to those of ordinary skill in the art by describing in detail exemplary embodiments with reference to the attached drawings in which:
- Fig. 1: schematically illustrates a method for connecting a flexible printed circuit, FPC, to battery cell of a battery module according to an embodiment;
- Fig. 2: illustrates a schematic top view of a battery system according to a first embodiment;
- Fig. 3: illustrates a more detailed top view of the battery system of Figure 2;
- Fig. 4: illustrates a schematic top view of a battery system according to a second embodiment; and
- Fig. 5: schematically illustrates flexible printed circuits used in embodiments.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Processes, elements, and techniques not considered necessary to those having ordinary skill in the art for a complete understanding of the aspects and features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise. As used herein, the term "and/or" includes any and all combinations of one or more of the associated listed items. Expressions such as "at least one of," when preceding a list of elements, modify the entire list of elements and do not modify the individual elements of the list.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention. As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

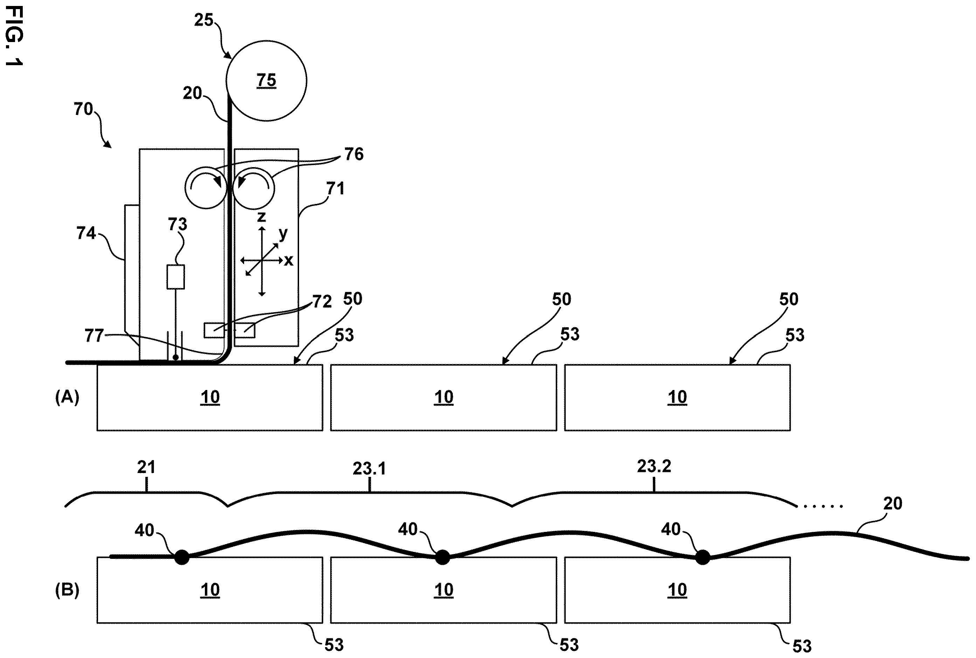

Figure 1 schematically illustrates a method for connecting a flexible printed circuit, FPC, 20 to battery cells 10 of a battery module 50 according to an embodiment. Therein, Figure 1 (A) illustrates an operation of a tool 70, particularly tool head 71, in the method of the invention.

In the method of the invention, a coil 25 of continuous FPC 20 is provided in a tool head 71 of a tool 70. The tool head 71 of Figure 1 is configured to move in all three dimensions in a translational manner as indicated by the arrows. As indicated in Figure 1, sections of FPC 20 can be unwound from the coil 25 of FPC 20 via two feed rolls 76. A section of FPC 20 drawn from the coil 25 initially extends vertically downward in the z-direction within the tool head 71 of the tool 70. The section of FPC 20 is then deflected by a rounded guiding mean 77 of the tool head 71 such that it extends in an area that is parallel to an area of the contact portions, i.e., top surfaces, of the battery cells 10. The deflection is therefore provided by the guiding means 77 and the moving of tool head 71 in the positive x-direction. Further, while the FPC 20 is unwound from the coil 25, a position of the FPC 20 is detected via optical sensor 72, e.g., by detecting a number of passed indicators periodically positioned on the FPC 20.

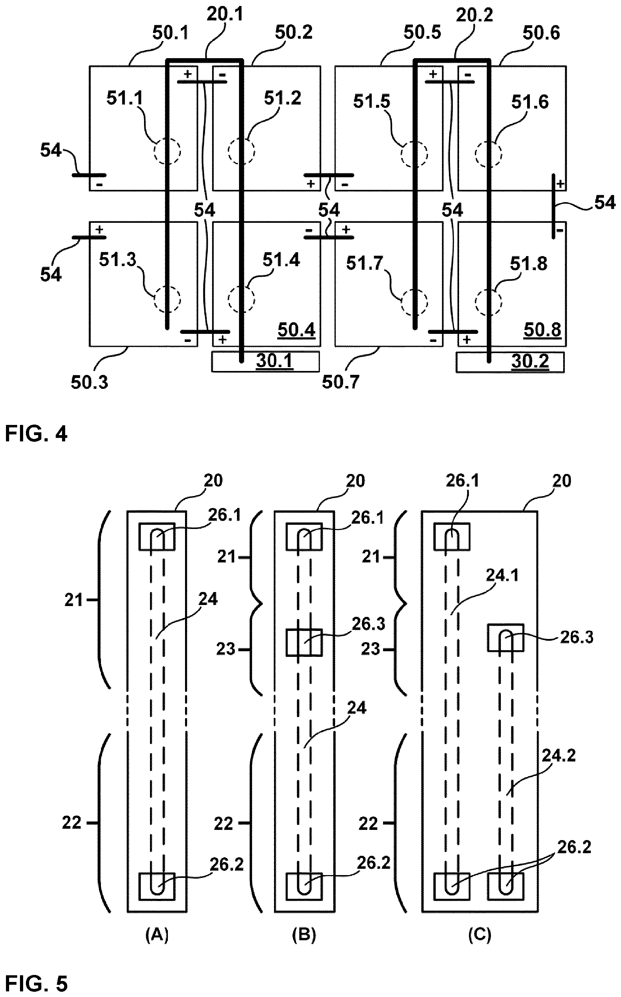

The tool head 71 further comprises a laser 73 for welding a first section 21 of the FPC 20 that extends parallely to an upper surface of a battery cell 10 to the upper surface of the battery cell 10, particularly to an upper surface of a battery cell case 53 of the battery cell 10. Particularly, a conductive structure of the FPC 20 as described in more detail with respect to Figure 5 is welded to the battery cell 10 by the laser 73. Hence, a weld connection 40 between the first section 21 of the FPC 20 and the battery cell 10 is formed as illustrated in Figure 1(B). As further illustrated in Figure 1(B), additional weld connections 40 are formed between other (third) sections 23.1, 23.2 of the FPC 20 by the repetition of the operations of the tool head 71 as described above with respect to Figure 1 (A). Therein, in between the weld connections 40, the tool head 71 not only performs a translational movement in the x-direction but also performs a curved movement in the z-direction so as to form a curved section of FPC 20 between the weld connections 40 to different battery cell 10 (or cases 53). Further, the operations of the tool head 71 are also repeated for providing a weld connection (not shown) between a contact pad (not shown) of a CSCB (not shown) in a similar manner.

The tool head 71 of the tool 70 according to the present invention comprises cutting means 74 for cutting the FPC 20 after making a weld connection between a conductive structure and a cell supervision circuit boards, CSCBs, contact pad. As described above, the tool head 71 comprises guiding means 77 for guiding an unwound section of the FPC 20 onto a contact portion of the battery module 50 or the contact pad of the CSCB. The cutting means 74 preferably interact with the FPC 20 while being guided by the guiding means 77 and separate an unwound section of the FPC 20 from the continuous portion of FPC at the coil 25. The cutting means 74 comprise a cutting edge mounted to the tool head and movable in z-direction. However, the cutting means may also be laser cutting means or a cutting saw for separation.

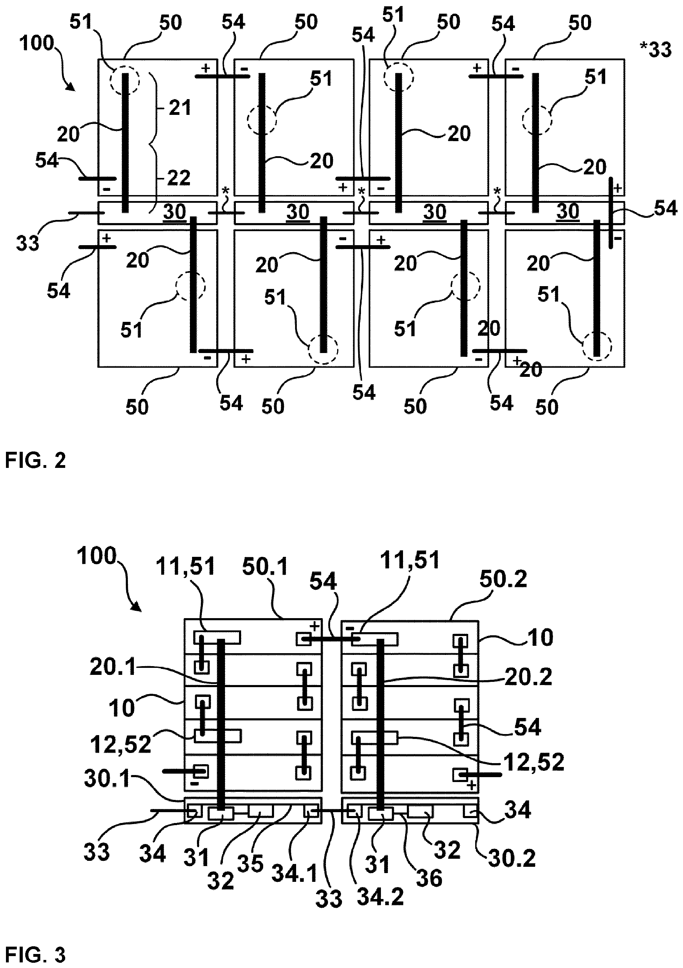

Figure 2 illustrates a schematic top view of a battery system 100 according to a first embodiment that was produced by the method of the present invention as schematically illustrated in Figure 1. The battery system 100 comprises a plurality of eighth battery modules 50, each of which comprises a plurality of stacked battery cells (not shown). The battery modules 50 are interconnected by busbars 54 that connect a positive terminal of one battery module 50 to a negative terminal of another battery module 50. Further, busbars 54 are also used to provide electric contact to a positive and a negative system terminal. The eight battery modules 50 are arranged in two rows of four battery modules 50 with a row of four cell supervision circuit boards, CSCBs, 30 arranged between a battery module 50 of the first row and a corresponding battery module 50 of the second row. Each of the CSCBs comprises a cell supervision circuit, CSC (not shown). Further, each of the battery modules 50 is connected to a corresponding CSCB via an FPC 20. Therein, the FPCs 20 were connected to the battery modules 50 via the method of the invention, i.e., by automatically forming a weld connection (not shown) between a conductive structure (not shown) of an FPC 20 in a first section 21 of the FPC and a contact portion 51 of a battery module 50. Further, the FPCs were connected to the CSCBs 30 via the method of the invention, i.e., by automatically forming a weld connection (not shown) between a conductive structure of an FPC 20 in a section 22 of the FPC and a contact pad (not shown) of a CSCB 30. Particularly, to each CSCB 30 two battery modules 50 were connected via two FPCs 20, i.e., via one linearly extending FPC 20 per battery module 50. As further illustrated in Figure 2, the first contact portions 51 of the battery modules 50 can be positioned differently in the first section 21 of the respective linearly extending stripe of FPC 20. As further illustrated in Figure 2, adjacent CSCBs are connected via FPC connectors 33.

Figure 3 illustrates a more detailed top view of the battery system 100 of Figure 2, particularly a more detailed top view of a section of the battery system 100 of Figure 2 with a first battery module 50.1 and a second battery module 50.2 from the upper row of the battery modules 50 as shown in Figure 2. Below the first battery module 50.1 is a first CSCB 30.1 and below the second battery module 50.2 is a second CSCB 30.2. As illustrated in Figure 3 in a purely exemplary manner, each of the battery modules 50 comprises five prismatic battery cells 10 that are stacked to each other in an aligned manner. The battery modules 50 may also comprise more battery cells, such as eight or twelve battery cells 10. Each of the battery cells 10 comprises a negative terminal 11 and a positive terminal 12 disposed on a top surface of the battery cell 10. Further, a positive terminal 12 of a battery cell 10 is connected to a negative terminal 11 of an adjacent battery cell 10 via a busbar 54 and a positive terminal 12 of one battery cell 10 of first battery module 50.1 is connected to a negative terminal 11 of one battery cell 10 of adjacent second battery module 50.2.

Further, the first battery module 50.1 is connected via a first FPC 20.1 to a contact pad 31 of the first CSCB 20.1 and the second battery module 50.2 is connected via a second FPC 20.2 to a contact pad 31 of the second CSCB 20.2. Therein, each of the FPCs 20.1, 20.2 is connected to the respective battery module 50.1, 50.2 in a contact portion. Particularly a first contact portion 51 of the battery modules 50.1, 50.2 is a negative terminal 11 that is extended laterally so as to provide an additional contact area for a corresponding FPC 20.1, 20.2. Further, the second contact portion 52 of the battery modules 50.1, 50.2 is a positive terminal 12 that is extended laterally so as to provide an additional contact area for a corresponding FPC 20.1, 20.2. In other words, a weld connection (not shown) is formed between the FPCs 20.1, 20.2 and the first and second contact portions 51, 52 of the first and second battery module 50.1, 50.2.

Weld connections (not shown) are also formed between the first and second FPCs 20.1, 20.2 and the contact pads 31 of the first and second CSCB 30.1, 30.2, respectively. Therein, the weld connections are formed in section sections of the FPCs 20.1, 20.2, respectively. Further, the contact pads 31 of the CSCBs 30.1 and 30.2 are connected to respective cell supervision circuits, CSCs 32 of the respective CSCB 30 via a respective CSC communication line 35. In other words, a voltage signal from the battery modules 50.1, 50.2 received via the respective contact pad 31 is forwarded to the respective CSC 32 via a respective CSC contact pad line 36. Further, each of the CSCBs 31 comprises CSCB communication pads 34 that are connected to the respective CSC 32 via respective CSC communication lines 35. Further, a first CSC communication pad 34.1 of the first CSCB 30.1 is connected to a second CSC communication pad 34.2 of the second CSCB 30.2 via an FPC connector 33. Further, FPC connectors 33 are provided for connecting adjacent CSCBs 30 to each other, i.e., for forming a daisy chain connection between the CSCBs 30.

Figure 4 illustrates a schematic top view of a battery system 100 according to a second embodiment. Therein, the battery system 100 of Figure 4 is similar to the battery system 100 of Figure 2 and same components are denoted by same reference numerals and a repeated description is omitted. However, in the embodiment of Figure 4, battery modules are not connected to CSCBs in an individual manner but rather groups of four battery modules are connected to a CSCB via a common FPC. Particularly a first group of four battery modules 50.1, 50.2, 50.3, 50.4 is connected to a first CSCB 30.1 via a first FPC 20.1 and a second group of four battery modules 50.5, 50.6, 50.7, 50.8 is connected to a second CSCB 30.2 via a second FPC 20.2. Therein, each the first and second FPC 20.1, 20.2 is of an essential U-shaped configuration with the opening of the U-shape facing downward.

Particularly, the first FPC 20.1 is connected to a first contact portion 51.1 of the first battery module 50.1, to a first contact portion 51.2 of the second battery module 50.2, to a first contact portion 51.3 of the third battery module 50.3, to a first contact portion 51.2 of the fourth battery module 50.4 and to a contact pad of the first CSCB 30. Further, the second FPC 20.2 is connected to a first contact portion 51.5 of the fifth battery module 50.5, to a first contact portion 51.6 of the sixth battery module 50.6, to a first contact portion 51.7 of the seventh battery module 50.7, to a first contact portion 51.8 of the eighth battery module 50.8 and to a contact pad of the second CSCB 30.2. Therein, the contact portions may be configured as described with respect to Figure 4. However, the contact portions may also be formed by battery cell cases 53 of cells 10 or busbars 54 of the battery modules.

Figure 5 schematically illustrates flexible printed circuits 20 used in embodiments of the invention. Particularly, Figure 5(A) illustrates an FPC 20 according to a first embodiment having a conductive structure 24 embedded between two insulating flexible layers as indicated by the dashed lines of the conductive structure 24. The conductive structure 24 extends from a first section 21 of the FPC 20 to a second section 22 of the FPC 20. A first contact area 26.1 of the FPC 20 is exposed by an opening in the first section 21 and a second contact area 26.2 of the FPC 20 is exposed by an opening in the second section 22. Particularly, openings in an upper insulating layer expose the contact areas 26.1, 26.2 of the conductive structure 24 in the first and in the second sections 21, 22. The openings in the first and second sections 21, 22 are either preformed in the insulating layers or are formed during the welding process of the conductive structure 24.

Figure 5(B) illustrates an FPC 20 according to a second embodiment that differs from the first embodiment of Figure 5(A) in that a first contact area 26.1 of the conductive structure 24 is exposed by an opening in the first section 21, a second contact area 26.2 of the FPC 20 is exposed by an opening in the second section 22 and a third contact area 26.3 of the conductive structure 24 is exposed by an opening in another (third) section 23. The first and third contact area 26.1, 26.3 are configured for contacting a contact portion of a battery module and second contact area 26.2 is configured for contacting a CSCB contact pad. With the FPC 20 of the second embodiment a voltage signal of two battery cells 10 is obtained.

Figure 5(C) illustrates an FPC 20 according to a third embodiment that differs from the first and second embodiments of Figures 5(A),(B) in that it comprises a first conductive structure 24.1 and a second conductive structure 24.2. Therein, the first conductive structure 24.1 comprises a first contact area 26.1 that is exposed by an opening in the first section 21 and a second contact area 26.2 that is exposed by an opening in the second section 22. Further, the second conductive structure 24.2 comprises a third contact area 26.3 of the conductive structure 24 that is exposed by an opening in another (third) section 23 and also a second contact area 26.2 that is exposed by an opening in the second section 22. With the FPC (20) of the third embodiment two voltage signals of two cells 10 are obtained.

### Reference signs

- 10: battery cell
- 11: negative terminal
- 12: positive terminal
- 20: flexible printed circuit, FPC
- 21: FPC first section
- 22: FPC second section
- 23: FPC further (third) section
- 24: FPC conductive structure
- 25: FPC coil
- 26: FPC contact area
- 30: cell supervision circuit board, CSCB
- 31: CSCB contact pad
- 32: cell supervision circuit, CSC
- 33: FPC connector
- 34: CSCB communication pad
- 35: CSC communication line
- 36: CSC contact pad line
- 40: weld connection
- 50: battery module
- 51: first contact portion
- 52: second contact portion
- 53: battery cell case
- 54: busbar
- 70: FPC connecting tool
- 71: tool head
- 72: optical sensor
- 73: (laser) welding means
- 74: cutting means
- 75: coil holder
- 100: battery system

## Claims

1. Method for connecting a flexible printed circuit, FPC, (20) to a battery system (100), the method comprising the steps of:
providing a coil (25) of a continuous and strip-shaped FPC (20),
unwinding a first section (21) of the FPC (20) from the coil (25), positioning the first section (21) over a first contact portion (51) of the battery module (50), and forming a weld connection (40) between a conductive structure (24) of the FPC (20) in the first section (21) and the first contact portion (51),
unwinding a second section (22) of the FPC (20) from the coil (25), positioning the second section (22) over at least one contact pad (31) of a cell supervision circuit board, CSCB, (30) and forming a weld connection (40) between the conductive structure (24) of the FPC (20) in the second section (22) and the at least one contact pad (31) of the CSCB (30), and cutting the first section (21) and second section (22) of the FPC (20) from the coil (25).

2. Method according to claim 1, wherein the first contact portion (51) of the battery module (50) is a battery cell terminal (11, 12), a battery cell case (53) or a busbar (54).

3. Method according to claim 1, wherein the FPC (20) is further connected to a second contact portion (52) of the battery module (50), wherein the first contact portion (51) is a negative terminal (11) of a battery cell (10) and the second contact portion (52) is positive terminal (12) of another battery cell (10).

4. Method according to claim 3, wherein the first contact portion (51) and the second contact portion (52) are connected to the conductive structure (24) of the FPC (20).

5. Method of claim 3, wherein the FPC (20) comprises a first conductive structure (24.1) and a second conductive structure (24.2) and wherein the first contact portion (51) is connected to the first conductive structure (24.1) and the second contact portion (52) is connected to the second conductive structure (24.2).

6. Method according to claim 5, wherein the first conductive structure (24.1) is connected to a first CSCB contact pad (31.1) and the second conductive structure (24.2) is connected to a second CSCB contact pad (31.2).

7. Method according to any one of the preceding claims, wherein a cell supervision circuit, CSC, (32) is disposed on the CSCB (30) and is connected to the at least one contact pad (31) of the CSCB (30).

8. Tool (70) for connecting a flexible printed circuit, FPC, (20) to a battery module (50) in a method according to any one of the claims 1 to 7, the tool (70) comprising a tool head (71) with a coil holder (75) configured for receiving a coil of a continuous and strip-shaped FPC (20), the coil holder (75) being rotatable such that a section of the continuous coil of FPC is unwound from the coil by the rotation of the coil holder,
wherein the tool head (71) is configured for performing a translational movement in three dimensions in an area parallel to a contact portion (51) of a battery module and a contact pad (31) of a cell supervision circuit board (30), for performing translational movement in a direction parallel to normal vectors of the contact portions (51, 52) and the CSCB contact pad (31),
wherein the tool head (71) comprises an optical sensor (72) for detecting a position of the unrolled FPC (20), and
wherein the tool head (71) comprises means (73) for making a weld connection (40) of a conductive structure (24) of the FPC (20) with the contact portion (51) and the CSCB contact pad (31).

9. Tool (70) according to claim 8, wherein the tool head further comprises guiding means (77) that are configured to receive a section of the unwound FPC and for guiding the section of unwound FPC into an area that is parallel to the contact portion (51) of the battery module (50).

10. Tool (70) according to claim 8 or 9, wherein the means for making a weld connection comprise a laser (73) for making a laser weld connection (40) between the FPC (20) the contact portion (51) and the CSCB contact pad (31).

11. Tool (70) according to any of claims 8 to 10, wherein the tool head (71) is further configured for performing a rotational movement around an axis that is parallel to the normal direction of the contact portions (51, 52) and the contact pad (31).

12. Tool (70) according to any one of claims 8 to 11, wherein the tool head (71) comprises cutting means (74) for cutting the FPC (20) after making a weld connection (40) between the conductive structure (24) and the CSCB contact pad (31).

13. Battery system (100) comprising a plurality of battery modules (50), wherein a contact portion (51) of each battery module is connected to a contact pad (31) of a cell supervision circuit board, CSCB, (30) via a flexible printed circuit (20) in a method according to any one of the claims 1 to 7 and using a tool according to any of the claims 8 to 11, wherein a first FPC (20.1) is connected to a first battery module (50.1) and a contact pad (31) of a first CSCB (30.1) and a second FPC (20.2) is connected to a second battery module (50.2) and a contact pad (31) of a second CSCB (30.2).

14. Battery system (100) according to claim 13, wherein an FPC (20) is connected to at least two battery modules (50.1, 50.2) and at least one contact pad (31) of a CSCB (30), wherein the FPC (20) comprises at least one curved section.

15. Battery system (100) according to claim 13 or 14, comprising a first CSCB (30.1) with a first communication pad (34.1) and a second CSCB (30.2) with a second communication pad (34.2), wherein the first and second communication pads (34.1, 34.2) are interconnected via a FPC connector (33) in a method according to any one of the claims 1 to 7 and using a tool according to any of the claims 8 to 12.

## Patentansprüche

1. Verfahren zum Verbinden einer flexiblen Leiterplatte, FPC, (20) mit einem Batteriesystem (100), wobei das Verfahren die folgenden Schritte umfasst:
Bereitstellen einer Rolle (25) aus einer durchgehenden und streifenförmigen FPC (20),
Abwickeln eines ersten Segments (21) der FPC (20) von der Rolle (25), Positionieren des ersten Segments (21) über einem ersten Kontaktabschnitt (51) des Batteriemoduls (50) und Ausbilden einer Schweißverbindung (40) zwischen einer leitenden Struktur (24) der FPC (20) in dem ersten Segment (21) und dem ersten Kontaktabschnitt (51),
Abwickeln eines zweiten Segments (22) der FPC (20) von der Rolle (25), Positionieren des zweiten Segments (22) über mindestens einem Kontaktpad (31) einer Zellenüberwachungsleiterplatte, CSCB, (30) und Ausbilden einer Schweißverbindung (40) zwischen der leitenden Struktur (24) der FPC (20) in dem zweiten Segment (22) und dem mindestens einen Kontaktpad (31) der CSCB (30) und Abschneiden des ersten Segments (21) und des zweiten Segments (22) der FPC (20) von der Rolle (25).

2. Verfahren nach Anspruch 1, wobei der erste Kontaktabschnitt (51) des Batteriemoduls (50) ein Batteriezellenanschluss (11, 12), ein Batteriezellengehäuse (53) oder eine Sammelschiene (54) ist.

3. Verfahren nach Anspruch 1, wobei die FPC (20) ferner mit einem zweiten Kontaktabschnitt (52) des Batteriemoduls (50) verbunden ist, wobei der erste Kontaktabschnitt (51) ein negativer Anschluss (11) einer Batteriezelle (10) ist und der zweite Kontaktabschnitt (52) ein positiver Anschluss (12) einer anderen Batteriezelle (10) ist.

4. Verfahren nach Anspruch 3, wobei der erste Kontaktabschnitt (51) und der zweite Kontaktabschnitt (52) mit der leitenden Struktur (24) der FPC (20) verbunden sind.

5. Verfahren nach Anspruch 3, wobei die FPC (20) eine erste leitende Struktur (24.1) und eine zweite leitende Struktur (24.2) umfasst und wobei der erste Kontaktabschnitt (51) mit der ersten leitenden Struktur (24.1) verbunden ist und der zweite Kontaktabschnitt (52) mit der zweiten leitenden Struktur (24.2) verbunden ist.

6. Verfahren nach Anspruch 5, wobei die erste leitende Struktur (24.1) mit einem ersten CSCB-Kontaktpad (31.1) verbunden ist und die zweite leitende Struktur (24.2) mit einem zweiten CSCB-Kontaktpad (31.2) verbunden ist.

7. Verfahren nach einem der vorhergehenden Ansprüche, wobei eine Zellenüberwachungsschaltung, CSC, (32) auf der CSCB (30) angeordnet ist und mit dem mindestens einen Kontaktpad (31) der CSCB (30) verbunden ist.

8. Werkzeug (70) zum Verbinden einer flexiblen Leiterplatte, FPC, (20) mit einem Batteriemodul (50) in einem Verfahren nach einem der Ansprüche 1 bis 7, wobei das Werkzeug (70) einen Werkzeugkopf (71) mit einem Rollenhalter (75) umfasst, der zum Aufnehmen einer Rolle aus einer durchgehenden und streifenförmigen FPC (20) konfiguriert ist, wobei der Rollenhalter (75) derart drehbar ist, dass ein Segment der durchgehenden Rolle aus FPC durch die Drehung des Rollenhalters von der Rolle abgewickelt wird,
wobei der Werkzeugkopf (71) zum Durchführen einer translatorischen Bewegung in drei Dimensionen in einem Bereich parallel zu einem Kontaktabschnitt (51) eines Batteriemoduls und einem Kontaktpad (31) einer Zellenüberwachungsleiterplatte (30), zum Durchführen einer translatorischen Bewegung in einer Richtung parallel zu Normalenvektoren der Kontaktabschnitte (51, 52) und des CSCB-Kontaktpads (31) konfiguriert ist,
wobei der Werkzeugkopf (71) einen optischen Sensor (72) zum Erfassen einer Position der abgerollten FPC (20) umfasst und
wobei der Werkzeugkopf (71) Mittel (73) zum Herstellen einer Schweißverbindung (40) einer leitenden Struktur (24) der FPC (20) mit dem Kontaktabschnitt (51) und dem CSCB-Kontaktpad (31) umfasst.

9. Werkzeug (70) nach Anspruch 8, wobei der Werkzeugkopf ferner Führungsmittel (77) umfasst, die konfiguriert sind, um ein Segment der abgewickelten FPC aufzunehmen, und zum Führen des Segments der abgewickelten FPC in einen Bereich, der parallel zum Kontaktabschnitt (51) des Batteriemoduls (50) ist.

10. Werkzeug (70) nach Anspruch 8 oder 9, wobei die Mittel zum Herstellen einer Schweißverbindung einen Laser (73) zum Herstellen einer Laserschweißverbindung (40) zwischen der FPC (20), dem Kontaktabschnitt (51) und dem CSCB-Kontaktpad (31) umfassen.

11. Werkzeug (70) nach einem der Ansprüche 8 bis 10, wobei der Werkzeugkopf (71) ferner zum Durchführen einer Drehbewegung um eine Achse konfiguriert ist, die parallel zur Normalenrichtung der Kontaktabschnitte (51, 52) und des Kontaktpads (31) ist.

12. Werkzeug (70) nach einem der Ansprüche 8 bis 11, wobei der Werkzeugkopf (71) Schneidmittel (74) zum Abschneiden der FPC (20) nach dem Herstellen einer Schweißverbindung (40) zwischen der leitenden Struktur (24) und dem CSCB-Kontaktpad (31) umfasst.

13. Batteriesystem (100), umfassend eine Vielzahl von Batteriemodulen (50), wobei ein Kontaktabschnitt (51) jedes Batteriemoduls in einem Verfahren nach einem der Ansprüche 1 bis 7 und unter Verwendung eines Werkzeugs nach einem der Ansprüche 8 bis 11 über eine flexible Leiterplatte (20) mit einem Kontaktpad (31) einer Zellenüberwachungsleiterplatte, CSCB, (30) verbunden ist, wobei eine erste FPC (20.1) mit einem ersten Batteriemodul (50.1) und einem Kontaktpad (31) einer ersten CSCB (30.1) verbunden ist und eine zweite FPC (20.2) mit einem zweiten Batteriemodul (50.2) und einem Kontaktpad (31) einer zweiten CSCB (30.2) verbunden ist.

14. Batteriesystem (100) nach Anspruch 13, wobei eine FPC (20) mit mindestens zwei Batteriemodulen (50.1, 50.2) und mindestens einem Kontaktpad (31) einer CSCB (30) verbunden ist, wobei die FPC (20) mindestens ein gekrümmtes Segment umfasst.

15. Batteriesystem (100) nach Anspruch 13 oder 14, umfassend eine erste CSCB (30.1) mit einem ersten Kommunikationspad (34.1) und eine zweite CSCB (30.2) mit einem zweiten Kommunikationspad (34.2), wobei das erste und das zweite Kommunikationspad (34.1, 34.2) über ein FPC-Verbindungsstück (33) in einem Verfahren nach einem der Ansprüche 1 bis 7 und unter Verwendung eines Werkzeugs nach einem der Ansprüche 8 bis 12 miteinander verbunden sind.

## Revendications

1. Procédé de connexion d'un circuit imprimé souple, FPC, (20) à un système de batterie (100), le procédé comportant les étapes suivantes :
la fourniture d'une bobine (25) d'un FPC continu et en forme de bande (20),
le déroulement d'une première section (21) du FPC (20) à partir de la bobine (25), le positionnement de la première section (21) sur une première partie de contact (51) du module de batterie (50), et la formation d'une connexion soudée (40) entre une structure conductrice (24) du FPC (20) dans la première section (21) et la première partie de contact (51),
le déroulement d'une deuxième section (22) du FPC (20) à partir de la bobine (25), le positionnement de la deuxième section (22) sur au moins un plot de contact (31) d'une carte de circuit de supervision de cellule, CSCB, (30) et la formation d'une connexion soudée (40) entre la structure conductrice (24) du FPC (20) dans la deuxième section (22) et l'au moins un plot de contact (31) de la CSCB (30), et la découpe de la première section (21) et de la deuxième section (22) du FPC (20) à partir de la bobine (25).

2. Procédé selon la revendication 1, dans lequel la première partie de contact (51) du module de batterie (50) est une borne de cellule de batterie (11, 12), un boîtier de cellule de batterie (53) ou une barre omnibus (54).

3. Procédé selon la revendication 1, dans lequel le FPC (20) est en outre connecté à une deuxième partie de contact (52) du module de batterie (50), dans lequel la première partie de contact (51) est une borne négative (11) d'une cellule de batterie (10) et la deuxième partie de contact (52) est une borne positive (12) d'une autre cellule de batterie (10).

4. Procédé selon la revendication 3, dans lequel la première partie de contact (51) et la deuxième partie de contact (52) sont connectées à la structure conductrice (24) du FPC (20).

5. Procédé selon la revendication 3, dans lequel le FPC (20) comporte une première structure conductrice (24.1) et une deuxième structure conductrice (24.2) et dans lequel la première partie de contact (51) est connectée à la première structure conductrice (24.1) et la deuxième partie de contact (52) est connectée à la deuxième structure conductrice (24.2).

6. Procédé selon la revendication 5, dans lequel la première structure conductrice (24.1) est connectée à un premier plot de contact de CSCB (31.1) et la deuxième structure conductrice (24.2) est connectée à un deuxième plot de contact de CSCB (31.2).

7. Procédé selon l'une quelconque des revendications précédentes, dans lequel un circuit de supervision de cellule, CSC, (32) est disposé sur la CSCB (30) et est connecté à l'au moins un plot de contact (31) de la CSCB (30).

8. Outil (70) de connexion d'un circuit imprimé souple, FPC, (20) à un module de batterie (50) dans un procédé selon l'une quelconque des revendications 1 à 7, l'outil (70) comportant une tête d'outil (71) avec un porte-bobine (75) configuré pour recevoir une bobine d'un FPC continu et en forme bande (20), le porte-bobine (75) étant rotatif de sorte qu'une section de la bobine continue de FPC soit déroulée à partir de la bobine par la rotation du porte-bobine,
dans lequel la tête d'outil (71) est configurée pour réaliser un mouvement de translation en trois dimensions dans une zone parallèle à une partie de contact (51) d'un module de batterie et un plot de contact (31) d'une carte de circuit de supervision de cellule (30), pour réaliser un mouvement de translation dans une direction parallèle à des vecteurs normaux des parties de contact (51, 52) et du plot de contact de CSCB (31),
dans lequel la tête d'outil (71) comporte un capteur optique (72) pour détecter une position du FPC (20) déroulé, et
dans lequel la tête d'outil (71) comporte des moyens (73) pour réaliser une connexion soudée (40) d'une structure conductrice (24) du FPC (20) à la partie de contact (51) et au plot de contact de CSCB (31).

9. Outil (70) selon la revendication 8, dans lequel la tête d'outil comporte en outre des moyens de guidage (77) qui sont configurés pour recevoir une section du FPC déroulé et pour guider la section du FPC déroulé dans une zone qui est parallèle à la partie de contact (51) du module de batterie (50).

10. Outil (70) selon la revendication 8 ou 9, dans lequel les moyens de réalisation d'une connexion soudée comportent un laser (73) pour réaliser une connexion soudée au laser (40) entre le FPC (20), la partie de contact (51) et le plot de contact de CSCB (31).

11. Outil (70) selon l'une quelconque des revendications 8 à 10, dans lequel la tête d'outil (71) est en outre configurée pour réaliser un mouvement de rotation autour d'un axe qui est parallèle à la direction normale des parties de contact (51, 52) et du plot de contact (31).

12. Outil (70) selon l'une quelconque des revendications 8 à 11, dans lequel la tête d'outil (71) comporte des moyens de découpe (74) pour découper le FPC (20) après réalisation d'une connexion soudée (40) entre la structure conductrice (24) et le plot de contact de CSCB (31).

13. Système de batterie (100) comprenant une pluralité de modules de batterie (50), dans lequel une partie de contact (51) de chaque module de batterie est connectée à un plot de contact (31) d'une carte de circuit imprimé de supervision de cellule, CSCB, (30) via un circuit imprimé souple (20) selon l'une quelconque des revendications 1 à 7 et en utilisant un outil selon l'une quelconque des revendications 8 à 11, dans lequel un premier FPC (20.1) est connecté à un premier module de batterie (50.1) et à un plot de contact (31) d'une première CSCB (30.1) et un deuxième FPC (20.2) est connecté à un deuxième module de batterie (50.2) et à un plot de contact (31) d'une deuxième CSCB (30.2).

14. Système de batterie (100) selon la revendication 13, dans lequel un FPC (20) est connecté à au moins deux modules de batterie (50.1, 50.2) et au moins un plot de contact (31) d'une CSCB (30), dans lequel le FPC (20) comporte au moins une section incurvée.

15. Système de batterie (100) selon la revendication 13 ou 14, comportant une première CSCB (30.1) avec un premier plot de communication (34.1) et une deuxième CSCB (30.2) avec un deuxième plot de communication (34.2), dans lequel les premier et deuxième plots de communication (34.1, 34.2) sont interconnectés via un connecteur de FPC (33) dans un procédé selon l'une quelconque des revendications 1 à 7 et en utilisant un outil selon l'une quelconque des revendications 8 à 12.
